(19) Europäisches Patentamt
European Patent Office
Office européen des brevets

(11) Publication number: **0 144 661 B1**

(12) **EUROPEAN PATENT SPECIFICATION**

(45) Date of publication of patent specification: **03.06.92** (51) Int. Cl.5: **H01L 21/312**

(21) Application number: **84112629.5**

(22) Date of filing: **19.10.84**

(54) **Method for forming a film of a polyimide dielectric material on an electronic component and the resulting component.**

(30) Priority: **30.11.83 US 556731**

(43) Date of publication of application:
**19.06.85 Bulletin 85/25**

(45) Publication of the grant of the patent:
**03.06.92 Bulletin 92/23**

(84) Designated Contracting States:
**DE FR GB**

(56) References cited:
**EP-A- 0 019 391**
**EP-A- 0 143 963**
**GB-A- 2 107 926**
**US-A- 4 164 458**

(73) Proprietor: **IBM DEUTSCHLAND GMBH**
**Pascalstrasse 100**
**W-7000 Stuttgart 80(DE)**

(72) Inventor: **Araps, Constance Joan**
**Route 376 and Myers Corner Road**
**Wappingers Falls, N.Y. 12590(US)**
Inventor: **Kandetzke, Steven Michael**
**5-8 Loudon Drive**
**Fishkill New York 12524(US)**
Inventor: **Takacs, Mark Anthony**
**10A Stuart Drive**
**Poughkeepsie New York 12603(US)**

(74) Representative: **Kreidler, Eva-Maria, Dr. rer. nat.**
**Schönaicher Strasse 220**
**W-7030 Böblingen(DE)**

**EP 0 144 661 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a method for forming thin films of a polyimide dielectric material on an electronic component and the resulting component as defined in the claims.

There is a significant interest in the semiconductor industry in replacing traditional inorganic dielectric materials with polymeric materials as device dielectric isolation layers, trenches, interlevel metal passivation layers, etc. Polymeric materials are less expensive, can be more easily purified and fabricated, and potentially have better thermal and electrical characteristics than some inorganic counterparts.

The European patent application in form of publication number EP-A-0019391 discloses a method for manufacturing electronic devices having a multilayer wiring structure using a polyimide dielectric material between the layers. The polyimide dielectric material is a thermosetting addition polymerization type polyimide which possesses imide rings in recurring units and a degree of polymerization which increases when cured due to the radical reaction of the end group or groups thereof. The thermosetting addition polymerization type polyimide possesses a molecular weight range from approximately 800 to approximately 20,000, preferably from approximately 1,000 to approximately 10,000. The uncured polyimide is precured by heating at approximately 220 °C, and completely cured by heating at approximately 350 °C (page 3, lines 2; 10).

The materials of the present invention differ in that they have a narrower range of molecular weights and superior properties which are directly attributable to the polymerizable oligomers and the range of molecular weights later described. Furthermore, the materials are cured at lower temperatures and by a different method from that disclosed in European patent publication EP-A-0019391.

U. S. patents 3,700,497; 3,946,166; 3,486,934; 3,515,585; 3,985,597; and 4,367,119 disclose polyimides, polyimide-polyamides or like materials used as insulating or passivating materials in electronic components. In detail, U. S. patent 3,700,497 relates to a method of making a semiconductor device which includes using a masking film composed of a thermoplastic type polyimide resin. In this method a structure of a semiconductor body, a silicon dioxide or a silicon nitride layer, and a metal film is covered with a film composed of a partially cured polyimide resin. Openings are etched through the film while it is in this state. Then the film is completely cured.

U. S. patent 3,846,166 relates to a method of producing a multilayer wiring structure for an integrated circuit wherein resin layers are employed as insulating layers between conductor layers. Any resin material having properties required for accomplishing the process of the invention, such as epoxy-, phenol-, polyimide-, polybenzimidazole resins, and combinations thereof can be used.

U. S. patent 3,985,597 relates to a process for forming an embedded interconnection metallurgy system on a substrate wherein a first layer of a polyimide plastic material is applied to a substrate, three layers are applied to said polyimide layer, the top layer consisting of a resist is exposed and developed to form an inverse pattern of the desired metallurgy pattern, the exposed areas of the underlying layers are removed, a blanket conductive metal layer is deposited over said structure, and all of the overlying layers are lifted-off by exposing the substrate to a solvent for the material of the bottom layer of the three-layer structure.

U. S. patent 4,367,119 provides a technique for building a planar multi-level metal-insulator structure. A dual composite mask for a lift-off multi-layered structure process is used in which a base component layer acts as an etch stop for the reactive ion etching of the overlying layers. The process is an improvement to the lift-off method described in U. S. patent 3,985,597.

None of the materials disclosed in the above references are equivalent to those of the present invention. The polyimide materials of the present invention can be used as a substitute for the polyimide and related materials disclosed in the above references.

Object of the present invention is a method for forming a thin film of a crosslinked three-dimensional cured product of a polymerizable oligomer on an electronic component, the same providing a dielectric or passivating effect.

The object of the invention is achieved by a method which comprises:

(A) applying to said electronic component a layer of a polymerizable oligomer selected from the group consisting of polyamic acids, the corresponding amic esters, the corresponding amic isoimides, the corresponding amic imides or mixtures thereof, wherein said polymerizable oligomer exhibits a number average molecular weight ranging from 2,000 to 4,000, and wherein the end groups of said polymerizable oligomer are end-capped with a vinyl or acetylenic end group; and

(B) curing said layer of polymerizable oligomer at temperatures below 300 °C using a combined dry/cure cycle, the catalytic technique thereby generating a three-dimensional cross-linked polymer network.

The resulting cured polyimide exhibits low extrinsic and intrinsic stress. The electronic component thus

formed is also included.

The polymerizable oligomer is a specified polyamic acid, the corresponding amic ester, the corresponding isoimide, the corresponding imide, analogues thereof, or mixtures thereof.

Major objects of the present invention are to provide dielectric and/or passivating materials for use in electronic component fabrication which are formed from polymerizable oligomers which have high solubility in conventional solvents, excellent wetting and planarizing properties and which can be fully cured or cross-linked without voids, bubbles, cracks, blistering, delamination or excess shrinkage. The resulting cured products thereof have excellent adhesion, thermal stability, electrical properties, chemical resistance and can be cured at conditions such that the resulting polymeric product exhibits reduced extrinsic and intrinsic stresses.

Hereafter, the above class of polymerizable oligomers with their range of molecular weights and end groups end-capped with a vinyl or acetylenic group will often merely be referred to as "polymerizable oligomers", and the resulting cross-linked, three-dimensional product will be referred to as a "cured polyimide" for brevity.

The major advantages of the present invention are directly attributable to the polymerizable oligomer which is used to yield the final cured polyimide layer.

Essentially the polymerizable oligomers of the present invention provide the processing and planarizing advantages of a monomer yet the cured polyimide obtained upon curing (cross-linking) per the present invention has the superior physical and chemical properties of a high molecular weight polymer.

The cured polyimide contains essentially no voids, bubbles, non-wet areas, cracking or delamination.

It exhibits a high degree of planarization, e.g., on the order of 95 %.

It can be uniformly etched back with no resultant residue.

It exhibits excellent adhesion to various surfaces, such as metals as are conventionally used in semiconductor fabrication, inorganic materials as are conventionally used e.g., silicon, silicon dioxide, silicon nitride, and the like, after final cure.

It is thermally stable to 400°C exhibiting negligible outgassing after 10 hours at 400°C, no adhesion loss and no morphological changes. The cured polyimide does not exhibit any substantial weight loss before 400°C.

It has excellent electrical properties, e.g., its dielectric constant does not change after exposure to water or thermal cycling and it is resistant to polarization and charge inversion.

It shows excellent chemical resistance, e.g., it has a minimal tendency to absorb process solvents and it does not swell or crack when exposed to metal lift-off solvents.

A final major advantage of the cured polyimide films of the present invention is that since they can be cured at relatively low temperatures, the resultant film stress typically observed at room temperature with conventional cured polyimide layers is not encountered to any substantial extent, whereupon polyimide cracking which is often observed when prior art cured polyimide layers are exposed to solvents during processing, e.g., solvent soaks to effect lift-off of conventional organic materials and metallization layers, or processing in situ stress, such as thermal stress, are not encountered.

The polymerizable oligomers of the present invention also exhibit highly desirable characteristics for use in forming dielectric and/or passivation films or layers in electronic components, though these properties are primarily from the process viewpoint as opposed to the final device viewpoint since, in the final device, they are cured.

These highly desirable properties include the ability to be cured at low temperatures to yield a three-dimensional cross-linked network involving carbon-to-carbon cross-linking, thereby providing a cured polyimide polymer matrix that exhibits minimum stress at device operation temperatures.

Because of their low molecular weight, solutions of high solids content can be prepared that are sufficiently fluid to coat surfaces of irregular topography using simple techniques which results in less solvent content and significantly less shrinkage and stress upon solvent evaporation. While if desired an adhesion promoter can be used in accordance with the present invention, it is one substantial benefit of the present invention that an adhesion promoter is not necessary.

The polymerizable oligomers of the present invention include the polyamic acid, the corresponding amic ester, the corresponding isoimide, the corresponding imide and analogues thereof. They can be represented by the formulae later set out.

As can be seen from the formulae, the end groups of the polymerizable oligomers are end-capped with a vinyl or acetylenic end group.

They are available under the trade name Thermid® from the National Starch and Chemical Corp.

As obtained, they typically have a molecular weight on the order from about 600 ~ 1000 to about 10,000, determined by GPC (gel permeation chromatography).

As one skilled in the art will appreciate, the molecular weights of the polymerizable oligomers of the present invention cannot be specified as a completely definite range since there is a variability in useful molecular weights depending upon the exact polymerizable oligomer selected, the solvent selected, the desire or non-desire to use multiple polymerizable oligomer applications, the desire or non-desire to have low solvent concentrations and like considerations as will be apparent to one skilled in the art. However, for most commercial process line operations, it is contemplated that useful polymerizable oligomers as used in the sense of the invention have a number average molecular weight in the range of from 2,000 to 4,000.

FORMULA 1
POLY(AMIC ACID

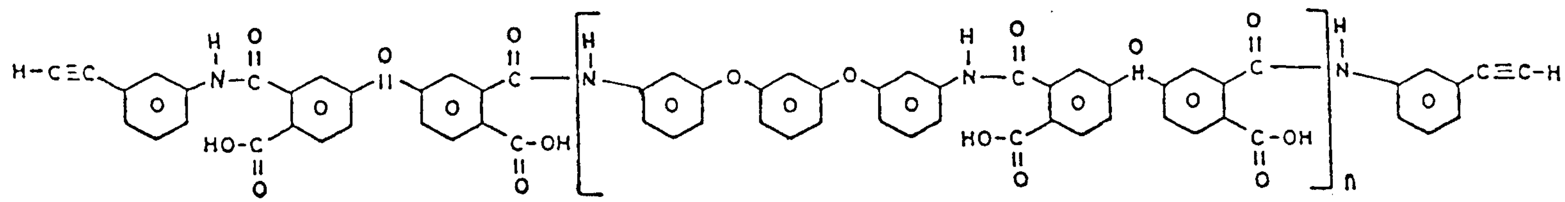

FORMULA 2
POLY (AMIC ESTER)

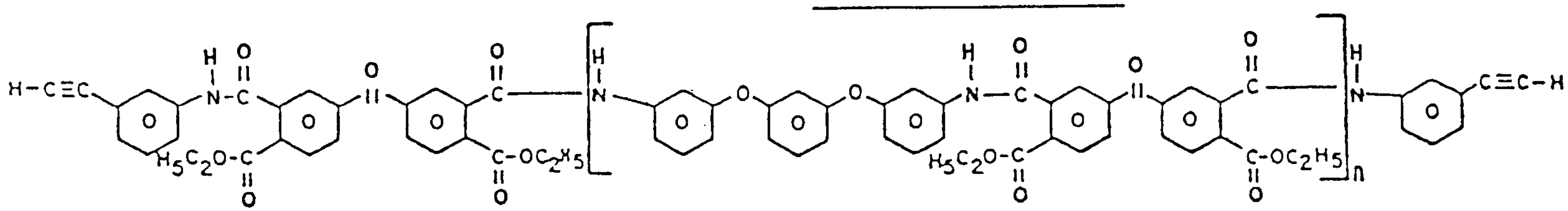

where n = 0 to about 50

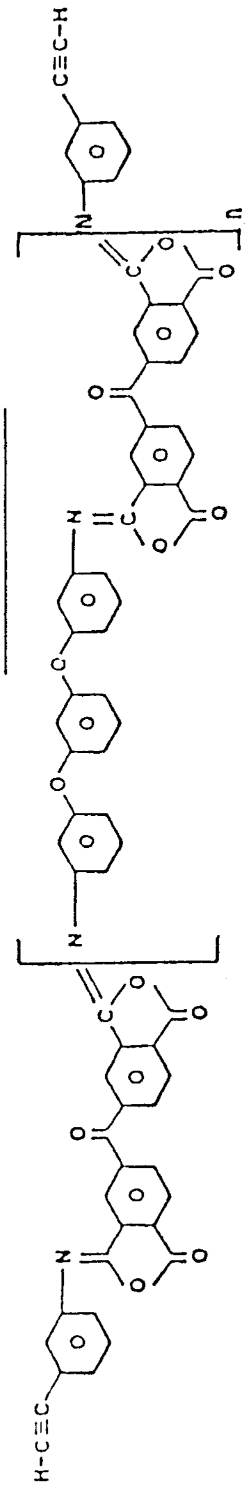

FORMULA 3
POLY (ISOIMIDE)

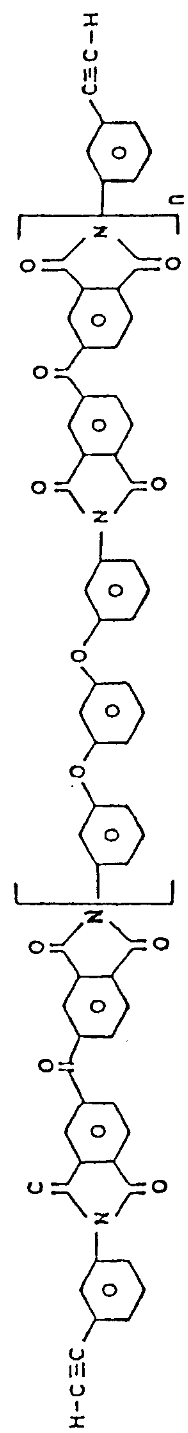

FORMULA 4
POLY (IMIDE)

where n = 0 to about 50

The polymerizable oligomers of the present invention are soluble in common organic solvents, for example, alcohols, ketones, ethers, amides, etc., a typical exemplary solvent being N-methyl pyrrolidinone (NMP). Since they are substituted with reactive terminae they can be cured or crosslinked to yield the desired dielectric and/or passivation material in situ to provide a strong three-dimensional network which provides the desired cured polyimide of high molecular weight and good thermal and chemical properties (as opposed to conventional polyimides which cure to yield a two-dimensional network).

Mixtures of solvents can be used if desired, but we currently see no benefit to using such mixtures unless oligomer as obtained from the vendor is in a solvent and more economical solvents are available. In such cases, a mixture of compatible solvents should be useful.

Where the oligomer is used as obtained from the vendor, the solvent content of the "as obtained" oligomer should be taken into account in determining the final amount of solvent needed for coating.

There are certain differences between the polyamic acid/ester, isoimide, imide, and analogue forms, and certain are preferred as now discussed.

As received, the Thermid® LR-600 amic acid (vendor information) of formula 1 has a molecular weight range of from about 600 to about 10,000. This material also contains a small amount of a gel fraction that appears on all GPC analysis as a high molecular weight fraction, e.g., on the order of 3,000,000. To obtain excellent wetting and film forming properties, it is most preferred that this commercial material be fractionated to remove the high molecular weight components, leaving a most preferred molecular weight fraction on the order of about 2,500 to about 3,000 (GPC analysis), with only traces of the gel fraction remaining.

Fractionation is performed in a conventional manner by dissolving the product as received in NMP (N-methylpyrrolidone), methyl isobutyl ketone and methyl alcohol, filtering the same through a one micron filter (which removes undissolved material having a molecular weight over about 4,000), precipating the same in toluene to remove a low molecular weight fraction, collecting the solids, dissolving the solids in acetone, filtering the same through a one micron filter, reprecipitating into toluene, collecting the resulting solid and drying, whereafter the resulting product having a molecular weight of about 2,500 to about 3,000 is dissolved in NMP and passed through a one micron filter to prepare the desired coating solution.

Fractionation should also reduce the ionic content of the polyamic acid and remove unreacted monomers which might contaminate the resin and reduce its thermal stability.

The fractionated product can be dissolved in a variety of ketonic solvents, NMP, etc., and exhibits improved wetting and film forming properties as compared to the as received material, providing defect-free smooth films.

The isoimide of formula 3 as received (Thermid® IP-600) is pre-cyclized from the amic acid of formula 1 during synthesis to yield the isomer of the imide form of formula 4. The isoimide of formula 3 is kinetically preferred but the imide of formula 4 is thermo-dynamically preferred as it is more stable and is, in any case, obtained upon heating either the amic acid of formula 1 or the isoimide of formula 3.

It is also contemplated in accordance with the present invention that copolymers of the oligomers of the present invention will be useful. An example of such a copolymer would be the polymerization product of an acetylene terminated oligomer with triethynyl benzene. Such copolymers are expected to have a higher moduli due to the presence of polytriethynyl benzene regions and are expected to have higher thermal and hydrolytic stability. The reduction in imide content would also reduce the susceptability of the cured polyimide to absorb water and polar solvents.

The polymerizable oligomers of the present invention which are end-capped with a vinyl or acetylenic end group per the present invention, most preferably an acetylenic group, which have formula 3 (the isoimide) are preferred to the amic acid of formula 1 or the imide of formula 4 for the following reasons.

The isoimide has a high degree of solubility, comparable to the amic acid, and will form concentrated solutions suitable for spin coating in ketonic solvents as well as NMP. The ketonic solvents appear to improve wetting and film forming properties. The imide analogue, however, dissolves only in NMP.

The isoimide softens at approximately 160 ° C, well below the onset of gelation (190 ° C; 6 minutes) and this capacity to soften before cross-linking occurs should result in superior planarization and film uniformity. The imide and amic acid soften at above 190 ° C.

The isoimide rearranges thermally to yield a cross-linked imide without the evolution of water or alcohol. This is a substantial benefit since water is tenaciously bound in polyimides and is not completely removed until samples are heated at 350 ° C, or above, for a minimum of 30 minutes. Continuous outgassing of solvent (NMP) and water during cross-linking could result in undesirable porosity and pin-holes.

The molecular weight distribution of the isoimide as received (powder form) is about 2,000-4,000 (GPC analysis) with no trace of a high molecular weight gel fraction. Thus, as opposed to the amic acid as received, Thermid® LR-600, no additional purification and/or fractionation need be conducted.

At present, we believe that only the amic acid as received requires fractionation.

Upon heating (150-300 ° C) the polymerizable oligomers of the present invention undergo three types of reactions: imidization via dehydration of the amic acid or elimination of alcohol from the amic ester functionalities and thermal rearrangement of the isoimide to yield the imide and radically induced addition reactions of the reactive terminal groups, be they vinyl or acetylenic end groups. The terminal end groups can add to other terminal end groups generating cross-links at chain ends or with carbonyl groups contained within the polyimide chain. These addition reactions deactivate the requisite reactive functional groups and generate the desired three-dimensional polymer network in the cured polyimide. As earlier noted, conventional linear polyimide resins undergo only imidization upon heating and result in a two-dimensional network.

As indicated, the polymerizable oligomers of the present invention are most typically applied to the desired substrate in the form of a solution. Because of their low molecular weight as earlier indicated, solutions of high solids content, e.g., on the order of 70 to 80 % by weight, can be prepared that are sufficiently fluid to coat surfaces of irregular topography and be easily planarized. Because of their low molecular weight, the polymerizable oligomer dissolves in ketones such as methyl isobutyl ketone, ethers such as bis-2-methoxy-ethyl-ether (diglyme) amides such as N-methyl pyrrolidinone, etc., resulting in a solution which readily wets a variety of surfaces, e.g., metals, silicon nitride, ceramic surfaces, silicon oxides etc.

For example, a solution of 45 % by weight polyamic acid has a viscosity of 0.3 Pa•s as compared to a 40 % solution of a conventional polyamic acid (duPont 5878) which has a viscosity of 50-80 Pa•s.

The ability to coat with a concentrated polymerizable oligomer solution results in a low solvent content and significantly less shrinkage and stress upon solvent evaporation.

The polymerizable oligomer solution can be coated by conventional methods such as spin coating, spray coating, meniscus coating etc.

These solutions are prepared merely by blending the polymerizable oligomer or mixtures thereof with the desired solvent or mixtures thereof, and thereafter coating and optionally drying the same, usually at less than about 100°C for about 1/2 to 2 hours, usually about 1 hour. The temperature of drying is not overly important, but it is normally desirable that the solvent be driven off without initiating any substantial degree of cross-linking. Usually inert atmospheres are used.

It is to be noted that a separate drying step is not mandatory per the present invention and, if desired, a combined dry/cure cycle can be used as later explained.

In fact, whether a separate drying step is used or a combined dry/cure cycle is used, the reason that we tend to use relatively long times for drying or for a combined dry/cure cycle is to ensure that all solvent is purged from the cured polyimide. As a matter of practice, catalytic curing itself proceeds at very low temperatures very rapidly, and thus where a separate drying step is performed, curing is rapid. However, since there is no need to use a separate drying step, a combined dry/cure step is used.

The thickness of the dry polymerizable oligomer film or layer is not overly important so long as the final cured polyimide exhibits its desired dielectric and/or passivating function, and is typically on the order of thicknesses as have been used for polyimides in the prior art to achieve this function.

Without being limitative in any fashion, typical thicknesses are on the order of about 1 µm to about 15 µm.

After the dried polymerizable oligomer film or layer is formed, the next active processing step insofar as the polymerizable oligomer is concerning is curing the same.

With respect to the solvent removal step, a slight amount of cross-linking during solvent removal is not unduly detrimental to the cured polyimide film of the present invention. However, since the polymerizable oligomers of the present invention tend to cross-link very rapidly once cross-linking conditions are reached, it is most preferred that substantially no cross-linking occur during solvent removal since volatilizing solvent might lead to voids, bubbles or the like. With this background in mind, we now turn to the preferred curing conditions which, of course, involve a catalytic cure.

While the polymerizable oligomers of the present invention find broad application in forming dielectric or passivating materials in electronic components, in the context of the present invention they are used primarily to form thin film dielectric or passivating layers, for example, thin films on the order of about 1 µm to about 15 µm. With such thin films, the stress generated during a high temperature cure leads to the problems earlier discussed in detail. While a thermal cure can be used to cure (cross-link) the polymerizable oligomers of the present invention, the stress problems earlier discussed can result. Accordingly, thermal curing the polymerizable oligomers of the present invention when used in thin film form is not preferred, albeit for certain non-critical applications theoretically such might be useful. Accordingly, the following discussion is directed primarily to catalytic cures which involve a low temperature curing regimen.

Thus, while curing can be by a number of procedures, e.g., thermal and chemical curing i.e. the combination thereof, for the reasons above, per the present invention it is most preferred to cure catalytically since in this instance stresses are not generated in the cured polyimide film, which might be the case with a high temperature cure. This is a major advantage of using the polymerizable oligomers of the present invention, i.e., high temperatures cures are not necessary due to the reactive end groups.

The atmosphere of curing is not important and is typically an inert gas, e.g., nitrogen, argon, etc., though other atmospheres could be used which would not degrade the polymerizable oligomer or the cured polyimide, e.g., air, vacuum etc.

When polyimide films are thermally cured at high temperatures, e.g., 400°C, the polymer is in

mechanical equilibrium at the elevated temperature where final cure is achieved but will be under considerable extrinsic and intrinsic stress at ambient temperature or at device use temperature, e.g., 25°-85°C. Conventional polyimide films cannot relax to relieve this stress since the polyimide is below its glass transition temperature (Tg on the order of 300°-400°C). Since conventional polyimides do not cross-link during curing, rather, have a two-dimensional structure, they are readily fractured under process conditions of high stress and readily swell in the presence of process solvents. Only polyimides of very long chain length and high molecular weight are resistant to cracking. These polyimides still swell when exposed to process solvents; however, and swelling, but these high molecular weight polyimides do not readily dissolve in common process solvents used for coating and form poor films due to poor wetting properties.

As earlier indicated, a major problem encountered with high temperature curing of polyimide thin films in semiconductor device fabrication is that the resultant film stress observed at room temperature (or device use temperature) can result in polyimide cracking when the film is exposed to solvents during processing or to thermal stress.

Per the present invention, to avoid this problem the soluble, low molecular weight polymerizable oligomers, which are capped with vinyl or acetylenic end groups, are catalytically cured.

Any catalyst can be used which will cause three-dimensional cross-linking of the polymerizable oligomers of the present invention, and the amount of catalyst required is simply that which will enable the catalysis reaction to effectively proceed.

Normally, the catalyst, or catalysts, if a stepped catalytic reaction is desired, is/are added to the solution of the polymerizable oligomer prior to coating the same.

The catalysts used per the present invention are conventional and can be freely selected from those in the prior art used to catalyze the cross-linking of monomers or oligomers to the cured polyimide form.

Useful catalysts include volatile peroxide catalysts such as benzoyl peroxide, dicumyl peroxide, etc.

As indicated, catalyst proportions are not overly important so long as the desired catalytic effect is achieved. Normally, however, proportions are on the order of about .05 to about 10 weight percent based on the weight of the polymerizable oligomer in the film or layer thereof prior to curing.

One substantial advantage, as indicated, of using a catalyst is that curing can be effected at low temperatures. The temperature selected obviously must be one that would activate the catalyst involved. For the peroxide catalysts, this is typically on the order of about 180°C to about 195°C. The time of curing is relatively unimportant when a catalyst is used since curing per se is very rapidly effected.

Again a combined dry/cure cycle is used. Primary drying is generally at a temperature where catalyst scission does not occur, e.g., about 1/2 to about 2 hours at a temperature lower than the catalyst scission temperature. Note in the Example about 40 minutes are spent at 170°C or less. Thereafter the temperature is stepped to over the catalyst scission temperature, e.g., to over 200°C, typically 200 ~ 300°C, normally for about 1 to about 2 hours. Of course, other curing cycles can be used.

As an alternative to heating such a catalytic system, ultraviolet radiation or electron beam radiation can be used to initiate the catalyst.

Conditions are selected in a conventional manner so as to initiate the catalyst. In any case, in using the thermal-catalytic reactions the final cross-linked density of the cured polyimide film will depend, of course, on the amount of catalyst used and the ratio of polymer repeating units to end groups. Typically the end groups will comprise on the order of about 1 to about 2 wt.% of the total polymer.

By developing the polymer three-dimensional network at low temperatures, minimized film stress at operating temperature should result. Imidization can be completed by a combination of chemical dehydration and thermal annealing after cross-linking has occurred which should not result in a significant change in the intrinsic stress in the cured polyimide film.

The three-dimensional network resulting from controlled radical coupling and addition reactions of the polymerizable oligomers of the present invention is significantly more resistant to deformation and cracking than are the two-dimensional conventional polyimide structures.

The presence of inter-chain cross-links should reduce the capability of the cured polyimide to outgas as a result of thermal degradation. Although bond scission will occur as a result of heating, fewer volatile groups are generated due to the presence of the cross-links.

Due to the higher carbon content and greater polymer density after curing as compared to conventional polyimides, the cured polyimide of the present invention is significantly more hydrophobic than conventional polyimides. For example, after conditioning for 1,000 hours at 50°C and 96 % relative humidity, the cured polyimide of the present invention contained less than 1 % water and no change in the dielectric constant thereof was observed.

It is to be noted that compounds represented by formula 3 and 4 can be imidized at room temperature by dehydration with dehydrating agents such as trifluoroacetic anhydride, acetic anhydride-acetic acid or

dicyclohexyl carbodiimides and then cured by cross-linking the same as earlier described. The amic acid and esters can be initially catalytically cured and then imidized by such dehydration techniques after the three-dimensional network has been formed.

Following curing, if it is desired or necessary to remove the cured polyimide of the present invention so as to planarize the surface thereof, this can be effected using a conventional reactive ion etching in a manner known in the art. Such is described in detail in "A Survey of Plasma-Etching Processes" by Richard L. Bersin, published in Solid State Technology, May 1976, pages 31-36, and "Reactive Ion Etching in Chlorinated Plasma" by Geraldine C. Schwartz et al, Solid State Technology, November 1980, pages 85-91. Following the procedure of these publications, the cured polyimide of the present invention can be uniformly etched back with no resultant residue.

The polymerizable oligomers of the present invention can be applied to any type of metallurgy as is conventionally used in electronic devices. We have encountered no problem with cured polyimide adhesion to any type of conventional metallurgy so long as, of course, the curing conditions are appropriately selected.

Of course, metallurgy which is formed on the cured polyimide must not be formed at a temperature which would degrade the cured polyimide or cause substantial outgassing during metallurgy deposition.

The metallurgy may be formed in a conventional manner, e.g., vacuum evaporation, sputtering, etc.

Metallurgy thicknesses as are conventionally used in the art.

In many instances, it may be necessary or desirable to pattern the polymerizable oligomer or cured polyimide layer or film formed per the present invention.

In this situation, after the polymerizable oligomer or cured polyimide layer or film is formed at the desired thickness, a conventional photoresist is applied, exposed and developed (removed) in a conventional manner to yield the desired pattern, whereafter the photopolymerizable oligomer or cured polyimide is removed in a conventional manner, typically using solvents as are known in the art.

Exposure and development of the photoresist is typically following vendor's instructions.

As one skilled in the art will appreciate, after a cured polyimide layer or film is formed per the present invention, additional layers of metallurgy or other conventional layers as are used in the semiconductor arts can be applied to the cured polyimide and processed as desired.

Since such processing steps are conventional, they will not be recited here in detail. For example, assuming that a first layer of metallurgy is formed and the cured polyimide layer of the present invention is formed thereon, a second layer of metallurgy could be formed on the cured polyimide layer in electrical connection through the openings in the cured polyimide layer (generated by the photoresist technique above) to the first metallurgy layer.

Thereafter, an additional layer or film of cured polyimide per the present invention could be formed on the metallurgy, processed as above, and further processing sequences conducted a number of times to build a multi-level structure where dielectric separation or isolation is achieved using the cured polyimide of the present invention.

Layers can also, of course, be passivated as desired in a conventional manner.

In essence, the above steps can be repeated a plurality of times until the desired device levels are obtained, typically levels of metallurgy, separated by the cured polyimide of the present invention.

Having thus generally described the invention, the following working example is offered to illustrate the same.

Example

The polymerizable oligomer selected was Thermid® IP-600 (the isoimide). It was obtained in powder form and had a molecular weight on the order of about 2,000 to about 4,000.

It was dissolved in NMP at ambient to provide a spinning or casting solution containing 30 weight percent of the isoimide based on solution weight.

For purposes of illustration, the substrate selected was silicon dioxide. This is a conventional semiconductor substrate. Of course, the isoimide could also be used as a direct replacement for the polyimide material of the earlier European patent application inform of the publication number EP-A-0019391.

A layer of typical metallurgy as is used in the art, in this case, Al-Cu (98 weight percent:2 weight percent) was formed on the silicon dioxide substrate in a conventional manner by standard vacuum evaporation.

The metallurgy was then patterned in a conventional manner using a standard positive photoresist following the vendor's instructions, thereby forming a metallurgical pattern on the silicon dioxide substrate.

The isoimide solution (earlier formed as indicated above at ambient conditions) was spun onto the

patterned metallurgy to a thickness of 2-5 μm.

No drying step was used, rather, a combined dry/cure step was used in an inert atmosphere, specifically nitrogen.

The time of temperature elevation was not important and was merely the time necessary to raise the atmosphere in the dry/cure furnace used from one temperature to the next. The times and temperatures were (starting at ambient) for comparison with catalytic cure: 85 °C, 10 minutes; 170 °C, one-half hour; 200 °C, one-half hour; 300 °C, one-half hour; and 400 °C, 4 and one-half hours. No catalyst was used, i.e., in this particular instance a straight thermal cure was used.

As earlier indicated, however, this can lead to substantial stress problems and is not preferred.

Accordingly, the above procedure was duplicated except that instead of using a straight thermal cure, a catalytic cure was used. Specifically, about 5 weight percent based on the weight of the isoimide of dicumyl peroxide was mixed at ambient temperature with the isoimide and NMP to form the spinning solution.

Again, a combined dry/cure was used at the following conditions: 85 °C, 10 minutes; 170 °C, one-half hour; 200 °C, one hour; 250 °C, one hour.

As earlier indicated, the major reason for using the relatively long times, during the combined dry/cure cycle using the catalytic technique, the time of course being shorter with the combined catalytic cure, is to ensure essentially complete solvent drive-off. If a separate drying step is used, substantially lesser times are required for the thermal catalytic cure cycle.

Following processing as above, the device intermediate was removed from the furnace and permitted to cool in the air at ambient conditions.

Conditions of cooling are not important; of course, the cooling rate should not be so fast that any device component would crack, but this will be apparent to one skilled in the art.

## Claims

**1.** Method for forming a thin film of a polyimide dielectric material on an electronic component comprising:

(A) applying to said electronic component a layer of a polymerizable oligomer selected from the group consisting of polyamic acids, the corresponding amic esters, the corresponding amic isoimides, the corresponding amic imides or mixtures thereof, wherein said polymerizable oligomer exhibits a number average molecular weight ranging from 2,000 to 4,000, and wherein the end groups of said polymerizable oligomer are end-capped with a vinyl or acetylenic end group; and

(B) curing said layer of polymerizable oligomer at temperatures below 300 °C using a combined dry/cure cycle catalytic technique thereby generating a three-dimensional cross-linked polymer network.

**2.** Method of claim 1 wherein said polymerizable oligomer is comprised of polyisoimide.

**3.** Method of claims 1 and 2 wherein the end groups of said polymerizable oligomer are end-capped with an acetylenic group.

**4.** Method of claims 1 to 3 wherein said polymerizable oligomer exhibits a number average molecular weight ranging from 2,500 to 3,000.

**5.** Method of claim 1 wherein said catalytic curing is accomplished using a combined dry/cure cycle in an inert atmosphere.

**6.** Method of claim 1 wherein said catalytic curing is accomplished using a combined dry/cure cycle ranging between 85 °C and 250 °C.

**7.** Method of claims 1, 5 and 6 wherein the catalyst utilized is a peroxide.

**8.** Method for forming superposed levels of metallurgy on an integrated circuit array comprising a semiconductor substrate, a dielectric layer on the substrate, a plurality of semiconductor devices integrated on the substrate, a first electrical conductor pattern on the dielectric layer electrically connected to at least one of the semiconductor devices wherein

(A) in accordance with preceding claims 1 to 4 a polyimide layer is formed on said first electrical conductor pattern;

(B) openings are lithographically formed in said polyimide layer;

(C) said polyimide layer is cured at temperatures below 300 °C using a combined dry/cure cycle in using the catalytic technique according to step (B) as given in claim 1;
(D) a second electrical conductor pattern in electrical connection through the openings to the first conductor pattern is formed on said cured polyimide layer, and
(E) the integrated circuit array is passivated.

**9.** Method of claim 8 which comprises repeating steps (A) through (D) until the desired levels of conductor patterns are obtained.

**10.** An electronic component comprising a film of a polyimide dielectric material formed by curing at temperatures below 300 °C as claimed in claim 1 inform of step(B) and in claim 8 inform of step(C) using a catalytic technique a layer of a polymerizable oligomer selected from the group consisting of polyamic acids, the corresponding amic esters, the corresponding amic isoimides, the corresponding amic imides or mixtures thereof, wherein said polymerizable oligomer exhibits a number average molecular weight ranging from 2,000 to 4,000, and wherein the end groups of said polymerizable oligomer are end-capped with a vinyl or acetylenic end group.

**Revendications**

**1.** Procédé pour former un film mince d'un matériau de type polyimide sur un composant électronique comprenant:
(A) l'application sur ce composant électronique d'une couche d'un oligomère polymérisable choisi dans le groupe consistant en acides polyamiques, les esters amiques correspondants, les isoimides amiques correspondants, les imides amiques correspondants et leurs mélanges, cet oligomère polymérisable ayant un poids moléculaire moyen en nombre de l'ordre de 2.000 à 4.000 et les groupes terminaux de cet oligomère polymérisable étant coiffés par un groupe terminal vinyle ou acétylénique; et
(B) le durcissement de cette couche d'oligomère polymérisable à des températures inférieures à 300 °C par une technique catalytique comprenant un cycle de séchage/durcissement combinés, de façon à générer un réseau tridimensionnel de polymère réticulé.

**2.** Procédé suivant la revendication 1, dans lequel cet oligomère polymérisable est composé de polyisoimide.

**3.** Procédé suivant les revendications 1 et 2, dans lequel les groupes terminaux de cet oligomère polymérisable sont coiffés par un groupe acétylénique.

**4.** Procédé suivant les revendications 1 à 3, dans lequel cet oligomère polymérisable présente un poids moléculaire moyen en nombre de l'ordre de 2.500 à 3.000.

**5.** Procédé suivant la revendication 1, dans lequel ce durcissement catalytique est accompli au moyen d'un cycle de séchage/durcissement combinés dans une atmosphère inerte.

**6.** Procédé suivant la revendication 1, dans lequel ce durcissement catalytique est accompli au moyen d'un cycle de séchage/durcissement combinés entre 85 °C et 250 °C.

**7.** Procédé suivant les revendications 1, 5 et 6, dans lequel le catalyseur utilisé est un peroxyde.

**8.** Procédé pour former des niveaux superposés de métallisation sur une matrice de circuits intégrés comprenant un substrat semiconducteur, une couche diélectrique sur le substrat, plusieurs dispositifs semiconducteurs intégrés sur le substrat, un premier motif conducteur électrique sur la couche diélectrique connecté électriquement à l'un au moins des dispositifs semiconducteurs, dans lequel :
(A) une couche de polyimide est formée selon les revendications précédentes 1 à 4 sur ce premier motif conducteur électrique;
(B) des ouvertures sont formées lithographiquement dans cette couche de polyimide;
(C) cette couche de polyimide est durcie à des températures inférieures à 300 °C avec un cycle de séchage/durcissement combinés suivant la technique catalytique décrite dans l'étape (B) de la revendication 1;

(D) un second motif conducteur électrique raccordé électriquement à travers les ouvertures au premier motif conducteur, est formé sur cette couche de polyimide durcie, et
(E) la matrice de circuits intégrés est passivée.

**9.** Procédé suivant la revendication 8, qui comprend la répétition des étapes (A) à (D) jusqu'à obtention des niveaux désirés de motifs conducteurs.

**10.** Un composant électronique comprenant un film d'un matériau diélectrique de type polyimide formé par durcissement à des températures inférieures à 300 °C suivant l'étape (B) de la revendication 1 et l'étape (C) de la revendication 8, au moyen d'une technique catalytique, d'une couche d'un oligomère polymérisable choisi dans le groupe consistant en acides polyamiques, les esters amiques correspondants, les isoimides amiques correspondants, les imides amiques correspondants et leurs mélanges, cet oligomère polymérisable ayant un poids moléculaire moyen en nombre de l'ordre de 2.000 à 4.000 et les groupes terminaux de cet oligomère polymérisable étant coiffés avec un groupe terminal vinyle ou acétylénique.

**Patentansprüche**

**1.** Verfahren zur Herstellung eines dünnen Films aus einem aus Polyimid bestehenden dielektrischen Material auf einer elektronischen Komponente, welches folgende Schritte umfaßt:
(A) Auftragen einer Schicht auf besagte elektronische Komponente aus einem polymerisierbaren Oligomer aus der Gruppe von Polyamidocarbonsäuren, den entsprechenden Amidocarbonsäureestern, den entsprechenden Amidocarbonsäureisoimiden, den entsprechenden Amidocarbonsäureimiden oder Mischungen derselben, wobei besagtes polymerisierbares Oligomer ein mittleres Molekulargewicht nach der Zahl im Bereich von 2,000 bis 4,000 aufweist, und die Endgruppen des besagten polymerisierbaren Oligomeren mit einer Vinyl- oder Acetylenendgruppe verschlossen sind; und
(B) Härten besagter Schicht aus dem polymerisierbaren Oligomer bei Temperaturen unter 300 °C unter Anwendung eines kombinierten Trocknungs/Härtungszyklus und einer katalytischen Technik, wodurch ein dreidimensional vernetztes Polymernetzwerk gebildet wird.

**2.** Verfahren nach Anspruch 1, bei dem das polymerisierbare Oligomer Polyisoimid umfaßt.

**3.** Verfahren nach den Ansprüchen 1 und 2, bei dem die Endgruppen des polymerisierbaren Oligomeren mit einer Acetylenendgruppe verschlossen sind.

**4.** Verfahren nach den Ansprüchen 1 bis 3, bei dem das polymerisierbare Oligomer ein mittleres Molekulargewicht nach der Zahl im Bereich von 2,500 bis 3,000 aufweist.

**5.** Verfahren nach Anspruch 1, bei dem besagte katalytische Härtung durchgeführt wird unter Anwendung eines kombinierten Trocknungs/Härtungszyklus in inerter Atmosphäre.

**6.** Verfahren nach Anspruch 1, bei dem besagte katalytische Härtung durchgeführt wird unter Anwendung eines kombinierten Trocknungs/Härtungszyklus in einem Temperaturbereich zwischen 85 °C und 250 °C.

**7.** Verfahren nach den Ansprüchen 1, 5 und 6, bei dem der verwendete Katalysator ein Peroxid ist.

**8.** Verfahren zur Ausbildung übereinander angeordneter Schichten eines Metallmusters auf dem Muster einer integrierten Schaltung, das ein Halbleitersubstrat, eine dielektrische Schicht auf dem Substrat, eine Vielzahl von Halbleiterschaltungen integriert auf dem Substrat, und ein erstes elektrisch leitendes Leiterzugmuster auf der dielektrischen Schicht, welches mit wenigstens einer der Halbleiterschaltungen elektrisch verbunden ist, umfaßt, bei dem:
(A) nach den vorhergehenden Ansprüchen 1 bis 4 eine Polyimidschicht auf besagtem erstem Leiterzugmuster gebildet wird;
(B) Öffnungen in besagter Polyimidschicht auf lithographischem weg gebildet werden;
(C) besagte Polyimidschicht bei Temperaturen unter 300 °C gehärtet wird unter Anwendung eines kombinierten Trocknungs/Härtungszyklus und einer katalytischen Technik nach Schritt (B) in Anspruch 1;
(D) ein zweites elektrisch leitendes Leiterzugmuster, welches durch die Öffnungen mit dem ersten Leiterzugmuster elektrisch verbunden ist, auf besagter gehärteter Polyimidschicht gebildet wird, und
E) das Muster der integrierten Schaltung passiviert wird.

**9.** Verfahren nach Anspruch 8, bei dem die Schritte (A) bis (D) so oft wiederholt werden, bis die gewünschte Anzahl der Schichten mit Leiterzugmustern erhalten ist.

**10.** Eine elektronische Kompomente, welche einen Film aus einem aus Polyimid bestehenden dielektrischen Material umfaßt, das durch Härtung bei Temperaturen unter 300 °C, wie in Anspruch 1 in Schritt (B) und in Anspruch 8 in Schritt (C) beansprucht, und unter Anwendung einer katalytischen Technik einer Schicht aus einem polymerisierbaren Oligomer aus der Gruppe von Polyamidocarbonsäuren, den entsprechenden Amidocarbonsäureestern, den entsprechenden Amidocarbonsäureisoimiden, den entsprechenden Amidocarbonsäureimiden oder Mischungen derselben gebildet wird, wobei besagtes polymerisierbares Oligomer ein mittleres Molekulargewicht nach der Zahl im Bereich von 2,000 bis 4,000 aufweist, und die Endgruppen des besagten polymerisierbaren Oligomeren mit einer Vinyl- oder Acetylenendgruppe verschlossen sind.